(19) Europäisches Patentamt / European Patent Office / Office européen des brevets

(11) **EP 2 660 977 B1**

(12) **FASCICULE DE BREVET EUROPEEN**

(45) Date de publication et mention
de la délivrance du brevet:
**29.04.2015 Bulletin 2015/18**

(51) Int Cl.:
***H03K 3/537*** *(2006.01)*

(21) Numéro de dépôt: **13002072.0**

(22) Date de dépôt: **19.04.2013**

(54) **Etage pour générateur de tension et générateur de tension associé**

Stufe für Spannungsgenerator, und entsprechender Spannungsgenerator

Stage for voltage generator and related voltage generator

(84) Etats contractants désignés:
**CH DE FR LI**

(30) Priorité: **20.04.2012 FR 1201183**

(43) Date de publication de la demande:
**06.11.2013 Bulletin 2013/45**

(73) Titulaire: **I.S.L. Institut Franco-Allemand de
Recherches de
Saint-Louis
68301 Saint-Louis Cedex (FR)**

(72) Inventeurs:
• **Duperoux, Jean-Pierre
34170 Castelnau Le Lez (FR)**
• **Pinguet, Sylvain
68128 Village-Neuf (FR)**
• **Schurrer, André
68220 Hegenheim (FR)**

(56) Documents cités:
**EP-A1- 0 162 766      GB-A- 401 737
GB-A- 509 614      US-A- 2 417 452**

EP 2 660 977 B1

**Description**

La présente invention concerne le domaine des condensateurs notamment en vue de leur application dans un générateur haute tension d'impulsions, de type MARX comprenant un grand nombre de condensateurs connectés électriquement en parallèle, des résistances ou inductances de charge connectées en série et des éclateurs, de telle sorte que la tension d'entrée charge en parallèle les condensateurs et que ceux-ci se déchargent en série via les éclateurs.

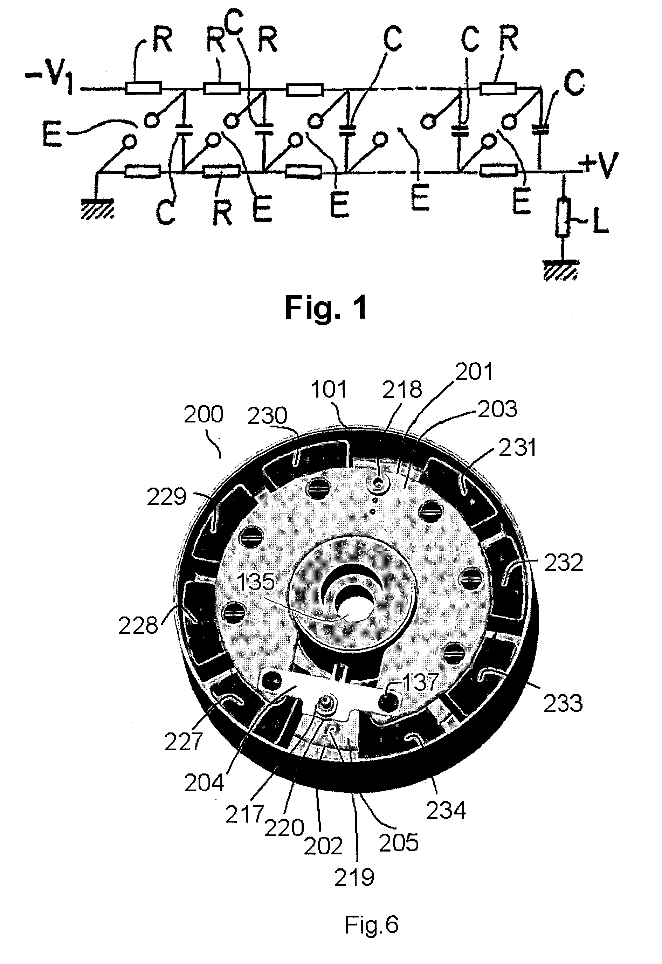

La figure 1 représente le schéma électrique d'un générateur de type MARX. Sur cette figure C désigne des condensateurs, R des résistances de charge et E des éclateurs comportant chacun deux demi-éclateurs.

Les condensateurs C, chargés en parallèle à la tension d'entrée V1 sont mis en série à l'aide d'éclateurs E.

Si n est le nombre d'étages ou le nombre de condensateurs C, l'amplitude de l'impulsion de la tension V2 appliquée à la charge est égale à :

$$V_2 = nV_1$$

Si on désigne par C la capacité d'un condensateur (ou d'un étage), la capacité équivalente de l'ensemble du générateur de MARX est égale à C/n. L'énergie stockée est égale à :

$$W = n \left( 1/2 \ C_T \ V_1^2 \right)$$

Après l'impulsion de déclenchement, les condensateurs C sont déchargés en série via les éclateurs E. L'impulsion de déclenchement est appliquée sur une électrode auxiliaire uniquement présente sur le premier éclateur. Les tensions aux bornes de chaque condensateur C sont mises en série, donc s'additionnent.

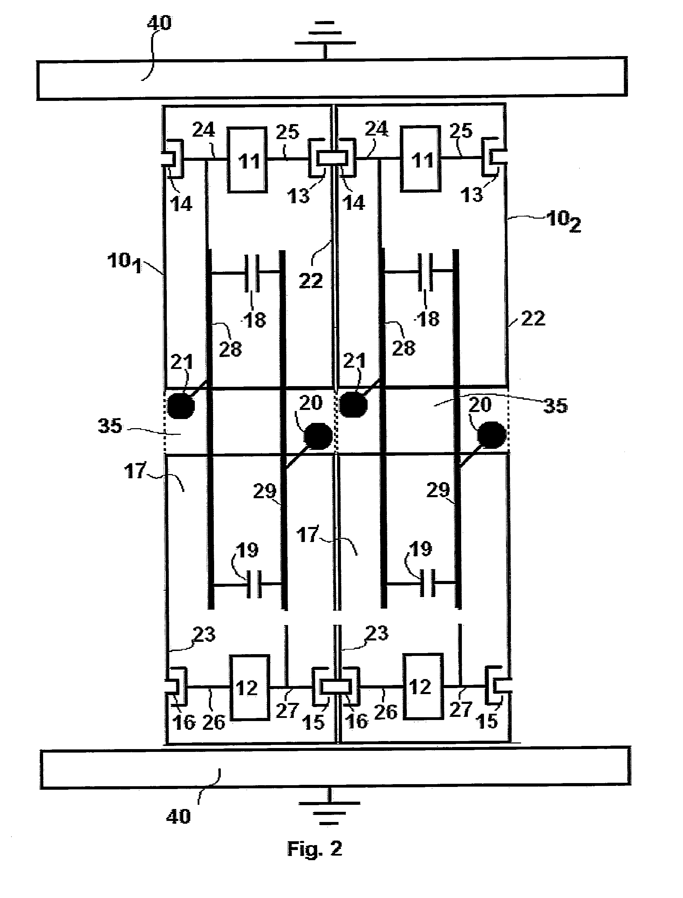

On connaît les générateurs de MARX et la figure 2 montre un schéma de seulement deux étages successifs d'un tel générateur, étages aussi appelés galettes dans la suite. Ce schéma comporte une première galette $10_1$ interconnectée sur sa face supérieure 22 à une seconde galette $10_2$ du générateur identique à la première, ces galettes étant connectées respectivement à une troisième et à une quatrième galettes non représentées pour un souci de simplicité. Ces galettes sont contenues dans une structure tubulaire rigide 40 réalisée dans un matériau non conducteur et sont constituées par un certain nombre d'éléments enrobés dans une résine 17 en forme de cylindre aplati avec un canal axial 35. La première galette $10_1$ est composée d'un bloc en résine 17 de forme cylindrique et aplatie et comportant une face supérieure transversale comportant un premier et un second borniers de connexion 13 et 15 et une face inférieure transversale 23 comportant un troisième et un quatrième borniers de connexion 14 et 16.

Le premier bornier 13 est connecté électriquement au troisième bornier 14 via respectivement une première connexion 24, une première inductance ou résistance de charge 11 et une seconde connexion 25.

Le second bornier 15 est connecté au quatrième bornier 16 via respectivement une troisième connexion 26, une seconde inductance ou résistance de charge 12 et une quatrième connexion 27.

Le troisième bornier 14 est aussi connecté à chacune des premières bornes de deux condensateurs 18 et 19 disposés en parallèle ainsi qu'à un premier demi éclateur 21 disposé au niveau de la surface transversale inférieure 23 de la galette $10_1$ et à proximité de son centre tandis que le second bornier 15 est aussi connecté à chacune des secondes bornes des dits condensateurs 18 et 19 disposés en parallèle ainsi qu'à un second demi éclateur 20 disposé au niveau de la surface transversale supérieure 22 de cette galette et à proximité de son centre. Ainsi, les premier et second borniers de la galette $10_1$ peuvent être connectés respectivement aux troisième et quatrième borniers de la galette $10_2$ tandis que le second demi éclateur 20 de la galette $10_1$ est en regard du premier demi éclateur 21 de la galette $10_2$.

Ainsi, ce générateur comporte au moins un condensateur par galette connectés électriquement en parallèle, les inductances ou résistances de charge étant connectées en série de telle sorte que la tension d'entrée charge en parallèle les condensateurs et que ceux-ci se déchargent en série via les éclateurs.

Le brevet britannique GB 401 737 A divulgue un appareil pour générer des impulsions haute tension dans lequel des condensateurs sont chargés en parallèle et déchargés en série, des éclateurs étant tous isolés dans un tube fermé, qui peut être localisé à l'intérieur ou à l'extérieur d'un réservoir contenant les condensateurs et des résistances de charge.

On connaît aussi la demande FR2823033 qui décrit un générateur haute tension d'impulsions, de type MARX comprenant un grand nombre de condensateurs connectés électriquement en parallèle, des résistances de charge connectées en série et des éclateurs, de telle sorte que la tension d'entrée charge en parallèle les condensateurs et que ceux-ci se déchargent en série via les éclateurs. Ce générateur est constitué par un bloc compact cylindrique comprenant des galettes superposées, chaque galette, aussi appelée étage, comportant plusieurs condensateurs connectés électriquement avec des résistances de charge et avec deux demi-éclateurs, l'ensemble étant noyé dans une résine isolante d'enrobage. De plus, chaque galette comprend au moins une série de condensateurs juxtaposés de façon à former une couronne, chaque condensateur formant un secteur de ladite couronne, les condensateurs étant reliés de chaque coté à une plaque conductrice ou à des circuits imprimés haute tension. Chacun des deux demi-éclateurs d'un même étage forme un éclateur avec un demi éclateur de l'étage adjacent aval pour l'un, et avec un demi-éclateur de l'étage adjacent amont pour l'autre.

Ce concept de galette permet de réaliser un générateur de Marx modulaire dont la tension de sortie maximale est définie par le nombre d'étages, donc de galettes superposées. En outre, la conception spécifique de ces étages est telle que les éclateurs sont disposés dans un canal central contenant un gaz sous pression et permettant leur déclenchement simultané. Ce phénomène d'avalanche est amélioré par effet photoélectrique lié à la forte production de rayonnement ultraviolet au moment de la décharge électrique au niveau des éclateurs.

L'énergie stockée dans un tel générateur dépend d'une part des caractéristiques physiques des condensateurs et du nombre d'étages du générateur et, d'autre part de la tension de charge appliquée à chacun des étages. Or augmenter la taille des condensateurs ou du nombre d'étages accroît l'encombrement du générateur tandis que l'augmentation de la tension de charge provoque un phénomène de claquage en surface par contournement mettant en court circuit l'étage correspondant.

Un générateur selon la demande de brevet FR2823033 présente aussi l'inconvénient de ne pas pouvoir être réalisé lorsqu'on ne dispose pas d'installation d'enrobage. De plus, ce type de galettes en résine nécessite l'usage de condensateurs non enrobés, la résine de la galette devant être coulée en une seule fois. Or, les condensateurs sont particulièrement sensibles aux contraintes mécaniques et s'oxydent très rapidement si bien que l'enrobage dans la résine doit absolument être réalisé sans délai par le même fabricant. De plus, la résine, en se solidifiant, se rétracte et crée des contraintes mécaniques, en particulier sur les condensateurs particulièrement sensibles aux tensions mécaniques. Or l'adoption de nouvelles normes peut parfois conduire à une fragilisation des condensateurs, cette fragilisation étant pénalisante avant l'enrobage mais aussi pendant le fonctionnement de la galette.

Le but de l'invention est aussi de résoudre les inconvénients précités en proposant une nouvelle conception d'étage de générateur de MARX aux spécifications de tenues mécanique et diélectrique ainsi que de fiabilité supérieures à celles des produits développés auparavant.

La solution apportée est un étage pour générateur de tension comportant au moins un condensateur et deux résistances de charge ou deux inductances de charge connectés électriquement, comportant une enveloppe rigide en matériau électriquement isolant, de forme cylindrique et aplatie et comportant un canal axial renfermant, enrobés dans un gel, lesdits au moins un condensateur et deux résistances de charge ou deux inductances de charge connectés électriquement et en ce qu'au moins quatre liaisons électriques affleurent ou dépassent de cette enveloppe, caractérisé en ce que lesdits au moins un condensateur et deux résistances de charge ou deux inductances de charge connectés électriquement étant disposés entre une première structure annulaire supérieure et une seconde structure annulaire inférieure. Les liaisons électriques pouvant par exemple être constituées par des borniers de connexion ou par des connexions filaires.

Selon une caractéristique particulière l'enveloppe comporte une première partie creuse avec une première portion tubulaire extérieure et une seconde portion tubulaire intérieure, ces portions tubulaires étant coaxiales et solidarisées par une plaque annulaire à leurs bases et une seconde partie en forme de plaque annulaire, cette enveloppe étant par exemple isolante et en PVC.

Selon une caractéristique particulière facilitant la maintenance, une partie de l'enveloppe est fixée à l'autre partie de l'enveloppe ou à des moyens qui lui sont solidaires par des moyens de fixation amovibles, tels, par exemple, des inserts.

Selon une autre caractéristique, un étage selon l'invention comporte deux demi-éclateurs disposés, au moins en partie, dans le canal axial et connectés aux condensateurs et en ce que la seconde portion tubulaire comporte deux ouvertures, l'une située dans sa partie supérieure et l'autre dans sa partie inférieure, ces ouvertures reliant l'intérieur de la première partie de l'enveloppe avec le canal, chacune de ces ouvertures permettant le passage d'un demi-éclateur.

Pour en faciliter, la fabrication, un étage selon l'invention peut comporter au moins l'une des caractéristiques suivantes :

- lesdits au moins un condensateur et deux résistances de charge ou deux inductances de charge connectés électriquement sont enrobés dans un gel, par exemple un gel silicone,

- lesdits au moins un condensateur et deux résistances de charge ou deux inductances de charge connectés électriquement sont disposés entre une première structure annulaire supérieure et une seconde structure annulaire inférieure pouvant comporter chacune un arc d'anneau électriquement conducteur et un arc d'anneau non électriquement conducteur, ces arcs d'anneau pouvant être des demi-anneaux

- le premier demi-anneau conducteur est placé au dessus du quatrième demi anneau non conducteur et le second demi anneau non conducteur est placé au dessus du troisième demi anneau conducteur,

- la première structure annulaire supérieure et la seconde structure annulaire inférieure sont séparées par au moins deux entretoises,

- l'étage comporte un premier et un second taquets de connexion à un demi-éclateur, connectés respectivement au premier et au troisième demi-anneaux conducteurs,

- l'étage comporte un premier et un second condensateur, une première et une seconde inductance de charge, une première et une seconde entretoise, des premier second, troisième et quatrièmes borniers de connexion, des premier et second éclateurs.

L'invention concerne aussi un générateur de tension comportant au moins une galette selon l'invention.

Selon une caractéristique permettant d'accroître le rendement d'un générateur possédant un empilement d'au moins deux étages selon l'invention et caractérisé en ce qu'il comporte une enveloppe tubulaire entourant lesdits étages et comprenant une première enveloppe externe de forme tubulaire et réalisée en matériau électriquement conducteur, par exemple en aluminium et, d'autre part, une seconde enveloppe interne de forme tubulaire et réalisée en matériau non électriquement conducteur, par exemple en PVC, ces première et seconde enveloppes étant disposées coaxialement.

D'autres avantages et caractéristiques de la présente invention apparaîtront dans la description de différentes variantes de réalisation de l'invention, en regard des figures annexées parmi lesquelles :

- la figure 1 est un schéma électrique d'un générateur de MARX ;
- la figure 2 est un schéma électrique d'une partie d'un générateur de Marx ;
- la figure 3 est un schéma électrique d'une partie d'un générateur de Marx de type 18L comportant des galettes selon l'invention ;
- la figure 4 montre un exemple d'agencement des éléments d'une galette selon un mode de réalisation particulier de l'invention ;
- la figure 5 présente un mode de réalisation d'une enveloppe rigide d'une galette selon l'invention,
- la figure 6 montre un exemple d'agencement des éléments internes d'une galette selon un autre mode de réalisation particulier de l'invention,
- La figure 7 montre un schéma simplifié d'un générateur de tension comportant un empilement de 20 étages 200 selon la figure 6 de l'invention.

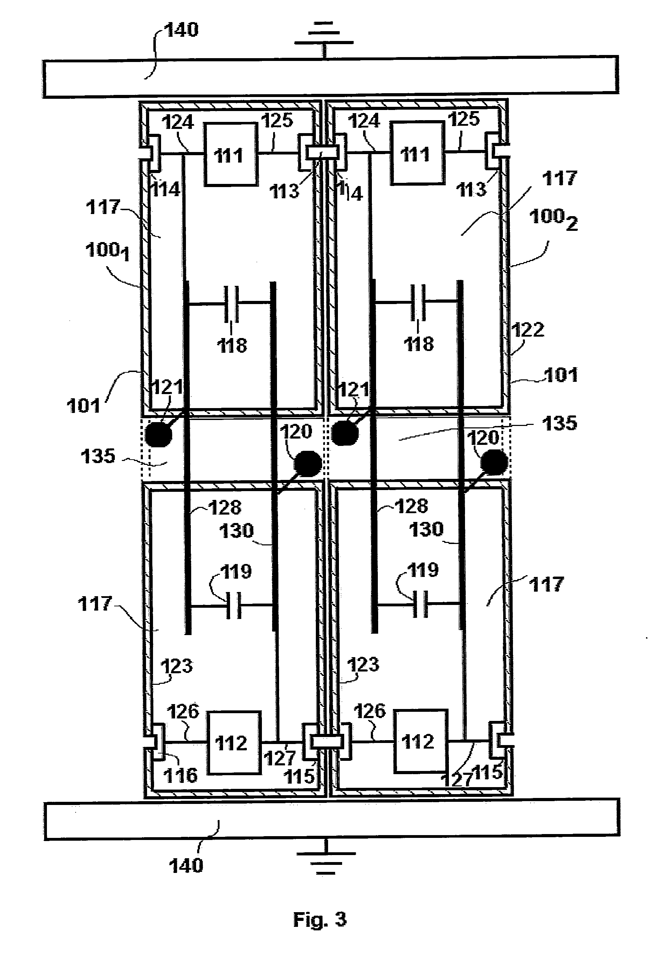

La figure 3 montre un schéma de seulement deux étages successifs d'un générateur de Marx comportant des galettes selon l'invention. Ce schéma comporte un premier étage $100_1$ interconnectée sur sa face supérieure 122 à un second étage $100_2$ du générateur, ces étages étant connectées respectivement à un troisième et à un quatrième étage non représentées pour un souci de simplicité. Ces étages sont contenues dans une structure tubulaire rigide 140 réalisée dans un matériau non conducteur.

Chacun de ces étages comporte une enveloppe rigide électriquement isolante 101 de forme cylindrique et aplatie et comportant un canal axial 135. Cette enveloppe renferme un certain nombre d'éléments enrobés dans du gel diélectrique 117, par exemple du gel silicone Cette enveloppe 101 comporte deux ouvertures sur sa face supérieure transversale 122 dans chacune desquelles est inséré un bornier ainsi que deux ouvertures sur sa face inférieure transversale 123 dans chacune desquelles est inséré un bornier.

Le premier étage $100_1$ est composée de l'enveloppe 101 comportant un premier et un second borniers de connexion 113 et 115 sur sa face supérieure transversale 122 avec et un troisième et un quatrième borniers de connexion 114 et 116 sur sa face inférieure transversale 123.

Le premier bornier 113 est connecté électriquement au troisième bornier 114 via respectivement une première connexion 124, une première inductance ou résistance de charge 111 et une seconde connexion 125.

Le second bornier 115 est connecté au quatrième bornier 116 via respectivement une troisième connexion 126, une seconde inductance ou résistance de charge 112 et une quatrième connexion 127.

Le troisième bornier 114 est aussi connecté à chacune des premières bornes de deux condensateurs 118 et 119 disposés en parallèle ainsi qu'à un premier demi éclateur 121 disposé au niveau de la surface transversale inférieure 123 de la galette $100_1$ et à proximité de son centre tandis que le second bornier 115 est aussi connecté à chacune des secondes bornes des dits condensateurs 118 et 119 disposés en parallèle ainsi qu'à un second demi éclateur 120 disposé au niveau de la surface transversale supérieure 122 de cet étage et à proximité de son centre. Ainsi, les premier et second borniers de l'étage $100_1$ peuvent être connectés respectivement aux troisième et quatrième borniers de l'étage $100_2$ tandis que le second demi éclateur 120 de l'étage $100_1$ est en regard du premier demi éclateur 121 de l'étage $100_2$.

Ainsi, ce générateur comporte deux condensateurs par galette connectés électriquement en parallèle, les inductances de charge étant connectées en série de telle sorte que la tension d'entrée charge en parallèle les condensateurs et que ceux-ci se déchargent en série via les éclateurs.

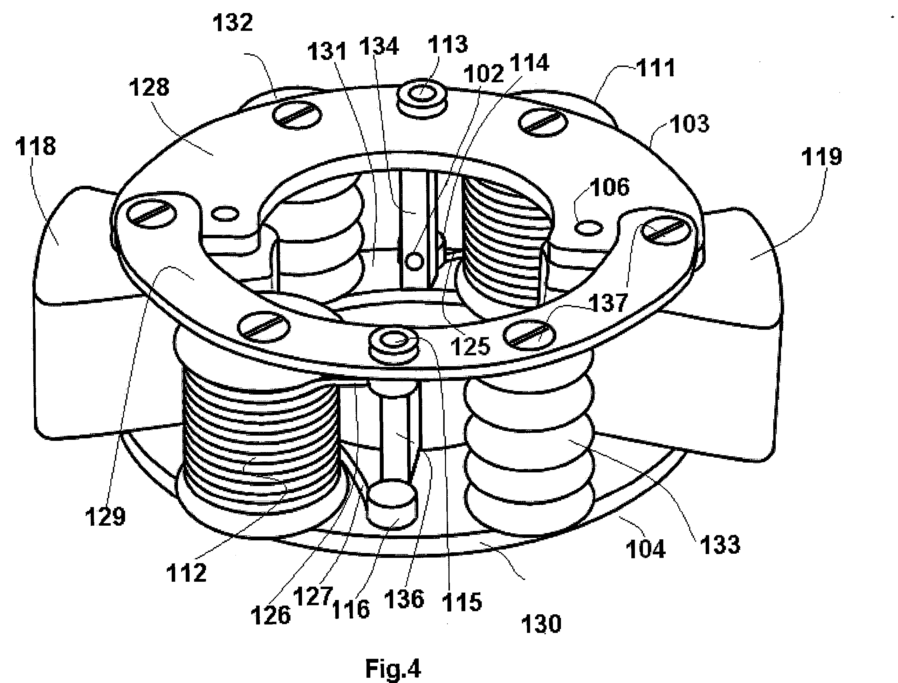

La figure 4 montre un exemple d'agencement des éléments d'un étage $100_1$ exceptés l'enveloppe 101 et les demi-éclateurs pour une question de simplification de la figure, ces demi-éclateurs pouvant être agencés comme dans le cadre de la figure 3 de la demande de brevet FR2823033.

Lesdits éléments sont constitués par une structure rigide annulaire supérieure 103, une structure rigide annulaire inférieure 104 et, insérés entre ces deux structures :

- une première et une seconde entretoise 132, 133
- un premier et un second condensateurs 118, 119
- une première et une seconde inductance de charge 111, 112
- une première partie des dits premier, second, troisième et quatrième borniers 113, 115, 114 et 116, ces borniers étant emmanchés dans des ouvertures pratiquées dans lesdites structures et comportant une seconde partie, de diamètre supérieur à celui de la première partie et disposée au dessus de la structure annulaire supérieure 103 pour les premier et second borniers 113, 115 et au dessous de la structure annulaire inférieure 104 pour les troisième et quatrième borniers de connexion 114, 116,

- un premier et un second taquet de connexion 134, 136.

Les premier et second condensateurs peuvent être, ou pas, enrobés par exemple avec une matière isolante et sont disposés de façon diamétralement opposée et il en est de même pour les première et seconde entretoises, les première et seconde inductances de charge, les premier et second taquets , les premier et seconds borniers et les troisième et quatrième borniers de connexion.

En outre, les borniers de connexion et les taquets sont disposés selon le même plan.

On trouve ainsi, dans le sens horaire, la succession d'éléments suivants :

Le premier condensateur 118, la première entretoise 132, les premier et troisième borniers 113, 114 et le premier taquet 134, la première inductance de charge 111, le second condensateur 119, la seconde entretoise 133, les deuxième et quatrième borniers 115, 116 et le second taquet 136, la second inductance de charge 112.

Les condensateurs, les entretoises et les inductances de charge sont fixées auxdites structures annulaires inférieure et supérieure par des vis 137.

La structure supérieure est composée d'un premier demi-anneau conducteur 128 et d'un second demi anneau non conducteur 129 solidarisés entre eux à leurs extrémités par des vis 137. De même, la structure inférieure est composée d'un troisième demi-anneau conducteur 130 et d'un quatrième demi anneau non conducteur 131 solidarisés entre eux à leurs extrémités par des vis 137. De plus, le premier demi anneau conducteur 128 est placé au dessus du quatrième demi anneau non conducteur 131 et le second demi anneau non conducteur 129 est placé au dessus du troisième demi anneau conducteur 130. En outre, le premier demi anneau conducteur 128 comporte au niveau de chacune de ses extrémités un alésage taraudé 106.

La première inductance de charge 111 est connectée aux premier et troisième borniers 113, 114 par des liaisons électriques filaires 124 et 125 et le premier bornier 113 est connecté électriquement à une première borne des condensateurs 118 et 119 par le premier demi-anneau conducteur 128.

La seconde inductance de charge 112 est connectées aux second et quatrième borniers 115, 116 par des liaisons électriques filaires 126 et 127 et le quatrième bornier 116 est connecté électriquement à une seconde borne des condensateurs 118 et 119 par le troisième demi-anneau conducteur 130. De plus, le premier taquet 134 est fixé, grâce à deux vis non représentées sur la figure, et connecté électriquement audit premier demi-anneau conducteur 128 et comporte une borne 102 de connexion pour le premier demi-éclateur 120 tandis que le second taquet 136 est connecté électriquement audit troisième demi-anneau conducteur 130 et comporte une borne de connexion pour le second demi-éclateur 121. Afin d'éviter des renforcements de champ à l'origine de claquages électriques, toutes les arêtes des borniers de connexion, des demi-éclateurs, des inductances, des entretoises, ainsi que des condensateurs sont arrondies.

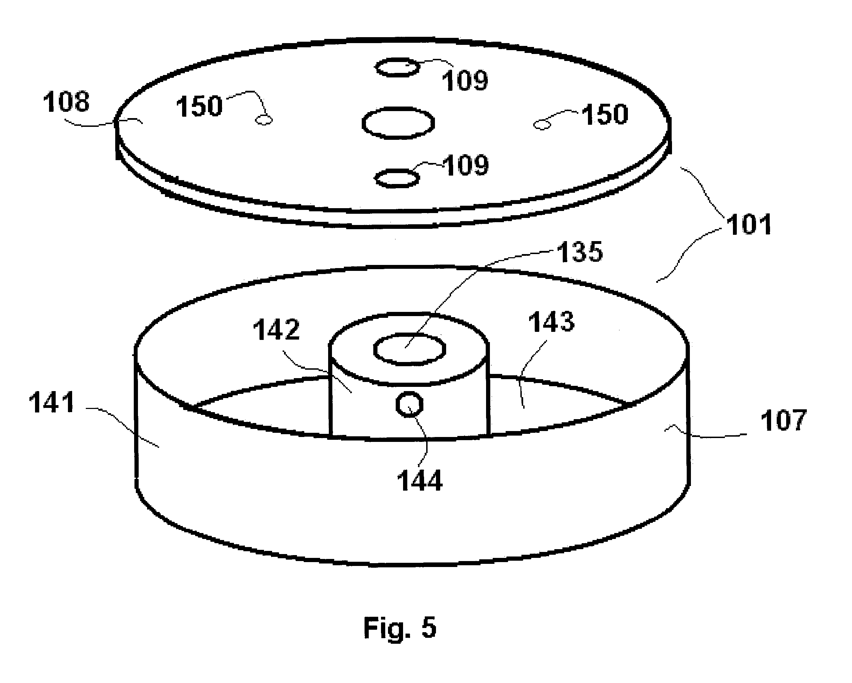

Comme montré sur la figure 5, l'enveloppe rigide 101 de forme cylindrique et aplatie, réalisée en matériau isolant, par exemple en PVC, comporte deux parties dont :

- une première partie creuse 107 en forme de moule à savarin à fond plat avec une première portion tubulaire extérieure 141 et une seconde portion tubulaire intérieure 142 formant le canal 135, ces portions tubulaires étant coaxiales solidarisées par une plaque annulaire 143 à leurs base
- une seconde partie 108 en forme de plaque annulaire destinée à être placée au dessus de la cavité de la première partie et fixée par vis audit premier semi-anneau conducteur 128 via les alésages taraudés 106, 150 et de sorte à former l'enveloppe.

Cette deuxième partie, ainsi que la plaque annulaire 143 comportent des ouvertures 109 permettant le passage des premier et second borniers 113 et 115, respectivement des troisième et quatrième borniers de connexion 114, 116 et une ouverture centrale prolongeant le canal 135. La seconde portion tubulaire 142 comporte deux ouvertures 144, l'une située dans sa partie supérieure et l'autre dans sa partie inférieure, ces ouvertures reliant l'intérieur de la première partie de l'enveloppe avec le canal 135, chacune de ces ouvertures permettant le passage d'un demi éclateur.

- La première partie creuse 107 de l'enveloppe est aussi fixée par des vis au dit troisième semi-anneau conducteur 130 via des alésages taraudés 106 pratiqués dans ce dernier.

Comme le diélectrique utilisé, à savoir le gel silicone 117 ne possède pas une bonne tenue mécanique, l'enveloppe 101 assure la rigidité du système et le protège des contraintes mécaniques extérieures notamment lors du montage du générateur. Elle garantit en outre, une bonne précision de l'assemblage des différents étages, rendant ainsi possible une grande précision de réglage des éclateurs.

Contrairement aux étages selon l'état de la technique, ce nouveau type d'étage permet l'utilisation de condensateurs pré-enrobés disponibles dans le commerce. Les impédances de charge des condensateurs intégrés à l'étage peuvent être des résistances carbone disponibles dans le commerce, ou bien des inductances spécialement conçues. Ces dernières permettent de faire fonctionner le générateur en régime répétitif.

Le procédé de fabrication d'un étage selon les figures précédentes peut être le suivant.

- Le premier demi-anneau conducteur 128 et le second demi-anneau non conducteur 129 sont solidarisés à l'un des premier et second condensateurs 118, 119 puis à l'autre par des vis 137 puis les inductances, les entretoises les premier et second bornier et le premier taquet 134 sont fixés à la structure annulaire supérieure 103.
- Le troisième demi-anneau conducteur 130 et le quatrième demi-anneau non conducteur 131 sont ensuite solidarisés sur les faces libres des premier et second condensateurs 118, 119, des entretoises 132, 133, des inductances 111, 112 puis les troisième et quatrième borniers 114, 116 et le second taquet 136 y sont fixés. Les extrémités filaires de la première inductance 111 sont ensuite connectées aux premier et troisième borniers 113, 114 tandis que celles de la deuxième inductance 112 sont connectées aux second et au quatrième borniers 115, 116.
- L'ensemble ainsi réalisé est placé dans la partie creuse de l'enveloppe de sorte que les connexions des taquets destinées chacune à recevoir un demi-éclateur se trouvent en regard des ouvertures 144 de ladite seconde portion tubulaire intérieure 142 de l'enveloppe.
- Les premier et second demi-éclateurs sont ensuite connectés respectivement aux premier et second taquets.
- La partie creuse 107 de l'enveloppe est ensuite remplie de gel silicone de façon à enrober ledit ensemble. Une fois que la partie creuse 107 est remplie, un couvercle isolant à savoir la seconde partie 108 en forme de plaque annulaire est fixée par vis au premier demi-anneau conducteur 128 permettant ainsi d'assurer une protection mécanique à l'ensemble. Seuls les quatre borniers de connexion et les deux supports pour les éclateurs restent accessibles.
- L'empilement d'étages selon l'invention pour former par exemple un générateur de Marx est ensuite réalisé suivant l'état de la technique connu.

Pour le fonctionnement, un circuit d'alimentation en courant charge, en parallèle, les condensateurs via les borniers de connexion, les inductances ou résistances de charges, et les premier et troisième demi-anneaux conducteurs, tandis qu'une fois chargés à la tension disruptive des éclateurs, les condensateurs se déchargent en série via les premier et troisième demi-anneaux conducteurs, les taquets et les demi-éclateurs.

Ce type d'étage permet de construire des générateurs de MARX compacts qui peuvent être utilisés dans différents domaines tels que l'émission d'ondes électromagnétiques, la radiographie-éclair, tests de compatibilités électromagnétiques, applications médicales et toutes autres applications nécessitant l'utilisation de tels générateurs

la figure 6 montre un exemple d'agencement des éléments d'un étage 200, exceptée la seconde partie en forme de plaque annulaire de l'enveloppe 101 pour une question de simplification de la figure.

Lesdits éléments internes sont constitués par une structure rigide annulaire supérieure 201, une structure rigide annulaire inférieure 202 et, fixés entre ces deux structures :

- huit condensateurs 227, 228, 229, 230, 231, 232, 233 et 234
- une première et une seconde résistance de charge,
- une première partie de premier, second, troisième et quatrième borniers 217, 218, 219, 220, ces borniers étant emmanchés dans des ouvertures pratiquées dans lesdites structures et comportant une seconde partie, de diamètre supérieur à celui de la première partie et disposée au dessus de la structure annulaire supérieure 201 pour les premier et second borniers 217, 218 et au dessous de la structure annulaire inférieure 202 pour les troisième et quatrième borniers de connexion 114, 116,
- un premier et un second taquet de connexion 220, 221.

En outre, deux demi-éclateurs, non représentés, sont disposés dans le canal central 135 de l'enveloppe 120 et reliés par des connexions électriques respectivement aux premier et second taquets de connexion 220, 221, chacune des connexions électriques passant au travers d'une ouverture 144 de ladite seconde portion tubulaire intérieure 142 de l'enveloppe 101.

En outre, les borniers de connexion et les taquets sont disposés selon le même plan. On trouve ainsi, dans le sens horaire, la succession d'éléments suivants :

Les condensateurs et les résistances de charge sont fixées auxdites structures annulaires inférieure et supérieure par des inserts, tels de vis.

La structure annulaire supérieure est composée d'un premier arc d'anneau conducteur 203 sur environ 315 degrés et d'un second arc d'anneau non conducteur 204 sur environ 45 degrés, ces arcs d'anneau étant solidarisés entre eux à leurs extrémités par des vis 137. De même, la structure inférieure est composée d'un troisième arc d'anneau conducteur 205 sur environ 315 degrés et d'un quatrième arc d'anneau non conducteur 206 sur environ 45 degrés, ces arcs d'anneau étant solidarisés entre eux à leurs extrémités par des vis. De plus, le premier arc d'anneau conducteur 203 est placé, en partie, au dessus du quatrième arc d'anneau non conducteur 206 et le second arc d'anneau non conducteur 204 est placé au dessus du troisième arc d'anneau conducteur 205.

La première résistance de charge, non visible sur le dessin car cachée par le second arc d'anneau non conducteur 204, relie le bornier 217 solidaire du second arc d'anneau non conducteur 204 au troisième arc d'anneau conducteur 205. La seconde résistance de charge, non visible sur le dessin car cachée par le premier arc d'anneau conducteur 203, relie le bornier solidaire du quatrième arc d'anneau non conducteur, lui-même non visible car caché par premier demi-anneau 203, au premier arc d'anneau conducteur 203.

Le premier bornier 217 est connecté électriquement à une première borne des condensateurs par le premier arc d'anneau conducteur 203 et le quatrième bornier est connecté électriquement à une seconde borne des condensateurs par le troisième arc d'anneau conducteur 205. De plus, le premier taquet 220 est fixé aux structures annulaires grâce à deux vis non représentées sur la figure, et connecté électriquement audit premier arc d'anneau conducteur 222 et comporte une borne de connexion pour le premier demi-éclateur tandis que le second taquet est connecté électriquement audit troisième arc d'anneau conducteur 205 et comporte une borne de connexion pour le second demi-éclateur 123.

Afin d'éviter des renforcements de champ à l'origine de claquages électriques, toutes les arêtes des pièces du montage sont arrondies, notamment celles en matériau conducteur. L'épaisseur des arcs d'anneau conducteurs est préférablement comprise entre 2 et 6 mm : elle doit être la plus faible possible afin d'optimiser la densité d'énergie du générateur.

Lorsqu'il y a suffisamment de condensateurs, comme par exemple dans le cas de la figure 6, il n'est pas nécessaire de placer des entretoises entre les structures annulaires inférieure et supérieure.

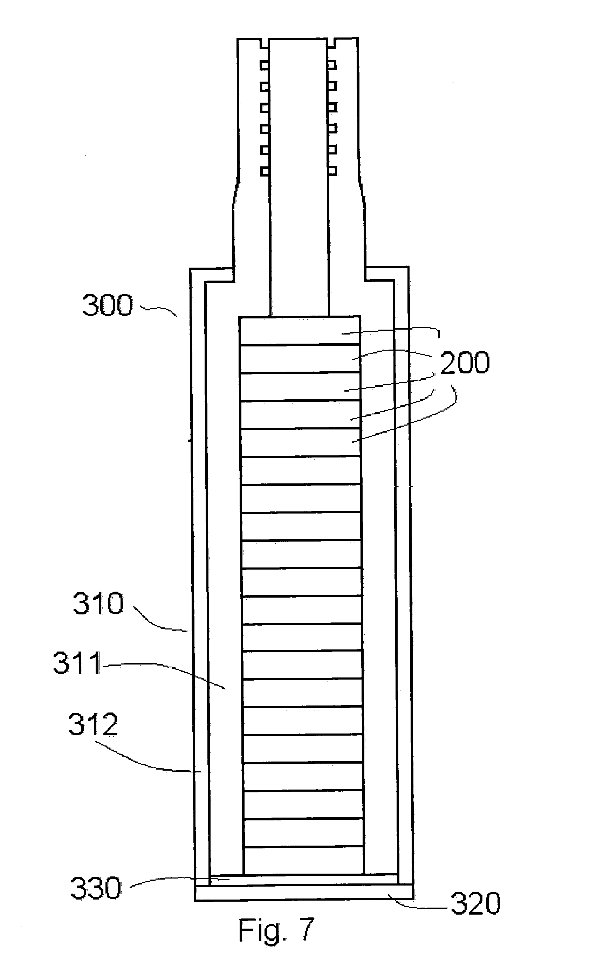

La figure 7 montre un schéma simplifié d'un générateur de tension comportant un empilement d'étages selon la figure 6 de l'invention.

Ce générateur 300 comporte une enveloppe tubulaire 310 à l'intérieur de laquelle sont placés vingt étages 200 selon la figure 6. L'enveloppe 310 du générateur comporte, d'une part, une première enveloppe externe 311 de forme tubulaire et réalisée en matériau électriquement conducteur, par exemple en aluminium et, d'autre part, une seconde enveloppe interne 312 de forme tubulaire et réalisée en matériau non électriquement conducteur, par exemple en PVC. Ces première et seconde enveloppes sont disposées coaxialement. L'enveloppe du générateur comporte en outre un couvercle amovible 320 permettant l'introduction des étages à l'intérieur du générateur. En outre, une plaque 330 en matériau isolant électriquement est disposée entre le couvercle 320 et le dernier étage $220_1$ introduit dans le générateur.

Par rapport à un générateur à simple enveloppe, un tel générateur avec une première enveloppe externe 311 électriquement conductrice et une seconde enveloppe interne 312 en matériau non électriquement conducteur possède un rendement plus élevé. En effet, cette double enveloppe permet de former une capacité supplémentaire de sorte que lors du déclenchement des éclateurs, cette capacité supplémentaire assure le maintien de la tension nominale au sein des étages et évite ainsi une chute de tension.

Bien entendu, de nombreuses modifications peuvent être apportées aux modes de réalisation précédemment décrits sans sortir du cadre de l'invention. Ainsi, les étages peuvent comporter un nombre différent de condensateurs, ces derniers étant alors répartis de façon différente entre les structures annulaires inférieure et supérieure.

Ce type de générateur est à même de fournir la quantité d'énergie nécessaire à l'émission de rayons-X.

Par ailleurs, une résine pourrait être utilisée à la place du gel silicone, voire un autre gel diélectrique.

De plus, les demi-éclateurs peuvent être connectés aux condensateurs sans les taquets de connexion par exemple en étant connectés directement aux demi-anneaux conducteurs correspondants par une connexion filaire.

Par ailleurs, l'angle des arcs d'anneau conducteurs des structures annulaires inférieure et supérieure est préférablement compris entre 150 et 330 degrés.

## Revendications

1. Etage pour générateur de tension comportant au moins un condensateur (118, 119) et deux résistances de charge ou deux inductances de charge (111, 112) connectés électriquement, comportant une enveloppe rigide en matériau électriquement isolant, (101) de forme cylindrique et aplatie et comportant un canal axial (135) renfermant, enrobés dans un gel, lesdits au moins un condensateur (118, 119) et deux résistances de charge ou deux inductances de charge (111, 112) connectés électriquement et en ce qu'au moins quatre liaisons électriques affleurent ou dépassent de cette enveloppe, **caractérisé en ce que**
lesdits au moins un condensateur (118, 119) et deux résistances de charge ou deux inductances de charge (111, 112) connectés électriquement étant disposés entre une première structure annulaire supérieure (103) et une seconde structure annulaire inférieure (104).

2. Etage selon la revendication 1, **caractérisé en ce que** les liaisons électriques sont constituées par des borniers de connexion (113, 114, 115, 116) ou par des connexions filaires.

3. Etage selon l'une quelconque des revendications 1 et 2, **caractérisé en ce que** l'enveloppe comporte une première partie creuse (107) avec une première portion tubulaire extérieure (141) et une seconde portion tubulaire intérieure (142), ces portions tubulaires étant coaxiales et solidarisées par une plaque annuaire (143) à leurs bases et une seconde partie (108) en forme de plaque annulaire.

4. Etage selon la revendication 1, **caractérisé en ce**

qu'il comporte deux demi-éclateurs disposés, au moins en partie, dans le canal axial et connectés aux condensateurs et **en ce que** la seconde portion tubulaire (142) comporte deux ouvertures (144), l'une située dans sa partie supérieure et l'autre dans sa partie inférieure, ces ouvertures reliant l'intérieur de la première partie de l'enveloppe avec le canal (135), chacune de ces ouvertures permettant le passage d'un demi éclateur.

5. Etage selon l'une quelconque des revendications 1 à 4, **caractérisé en ce que** ladite enveloppe (101) est en PVC.

6. Etage selon l'une quelconque des revendications 1 à 5, **caractérisé en ce que** lesdits au moins un condensateur (118, 119) et deux résistances de charge ou deux inductances de charge (111, 112) connectés électriquement sont enrobés dans un gel silicone (117).

7. Etage selon l'une quelconque des revendications 1 à 6, **caractérisé en ce que** chacune des première et seconde structures annulaires comporte un demi-anneau électriquement conducteur (128, 130) et un demi-anneau non électriquement conducteur (129, 131), le premier demi anneau conducteur (128) est placé, en partie, au dessus du quatrième demi-anneau non conducteur (131) et le second demi anneau non conducteur (129) étant placé au-dessus du troisième demi anneau conducteur (130).

8. Etage selon l'une quelconque des revendications 1 à 7, **caractérisé en ce que** la première structure annulaire supérieure (103) et la seconde structure annulaire inférieure (104) sont séparées par au moins deux entretoises (132, 133).

9. Etage selon l'une quelconque des revendications 1 à 8, **caractérisé en ce qu'**il comporte un premier et un second condensateur (118, 119), une première et une seconde inductance de charge (111, 112), une première et une seconde entretoise (132, 133), des premier second, troisième et quatrième borniers (113, 114, 115, 116) de connexion, des premier et second éclateurs (120, 121).

10. Générateur de tension comportant au moins un étage selon l'une quelconque des revendications 1 à 9.

11. Générateur de tension selon la revendication 10, possédant un empilement d'au moins deux étages selon l'invention et **caractérisé en ce qu'**il comporte une enveloppe tubulaire (310) entourant lesdits étages et comprenant une première enveloppe externe (311) de forme tubulaire et réalisée en matériau électriquement conducteur, par exemple en aluminium et, d'autre part, une seconde enveloppe interne (312) de forme tubulaire et réalisée en matériau non électriquement conducteur, par exemple en PVC, ces première et seconde enveloppes étant disposées coaxialement.

**Patentansprüche**

1. Spannungsgeneratorstufe mit mindestens einem Kondensator (118, 119) und zwei elektrisch verbundenen Lastwiderständen bzw. zwei Lastinduktivitäten (111, 112), bestehend aus einem starren Gehäuse aus elektrisch isolierendem Material (101), mit zylindrischer, flacher Form und einem Längskanal (135), welcher in ein Gel eingebettet mindestens einen Kondensator (118, 119) und zwei elektrisch verbundene Lastwiderstände bzw. zwei Lastinduktivitäten (111, 112) enthält, **dadurch gekennzeichnet, dass** mindestens vier Stromanschlüsse bündig in das Gehäuse eingelassen sind bzw. aus diesem herausragen und dass dieser mindestens eine Kondensator (118,119) und zwei elektrisch verbundene Lastwiderstände bzw. zwei Lastinduktivitäten (111, 112) sich zwischen einer ersten oberen ringförmigen Struktur (103) und einer zweiten unteren ringförmigen Struktur (104) befinden.

2. Generatorstufe gemäß Anspruch 1, **dadurch gekennzeichnet, dass** die Stromanschlüsse aus Anschlussklemmen (113, 114, 115, 116) oder aus Drahtverbindungen bestehen.

3. Generatorstufe gemäß einem der Ansprüche 1 und 2, **dadurch gekennzeichnet, dass** das Gehäuse einen ersten Hohlkörper (107) mit einem ersten äußeren röhrenförmigen Teil (141) und einem zweiten inneren röhrenförmigen Teil (142) beinhaltet, wobei diese beiden hohlen Teile koaxial sind und durch eine ringförmige Platte (143) an der Unterseite und eine zweite ringförmige Platte (108) verbunden sind.

4. Generatorstufe gemäß Anspruch 1, **dadurch gekennzeichnet, dass** sie zwei Halbfunkenstrecken enthält, welche zumindest teilweise im Axialkanal angebracht und mit den Kondensatoren verbunden sind und dadurch, dass der zweite röhrenförmige Teil (142) zwei Öffnungen (144) aufweist, wovon eine sich im oberen und die andere im unteren Bereich befindet, welche die Innenseite des ersten Teiles des Gehäuses mit dem Kanal (135) verbinden, wobei durch jede dieser Öffnungen eine Halbfunkenstrecke verläuft.

5. Generatorstufe nach einem beliebigen der Ansprüche 1 bis 4, **dadurch gekennzeichnet, dass** das Gehäuse (101) aus PVC ist.

6. Generatorstufe nach einem beliebigen der Ansprüche 1 bis 5, **dadurch gekennzeichnet, dass** der mindestens eine Kondensator (118, 119) und die zwei elektrisch verbundenen Lastwiderstände bzw. zwei Lastinduktivitäten (111, 112) in ein Silikon-Gel eingebettet sind.

7. Generatorstufe nach einem beliebigen der Ansprüche 1 bis 6, **dadurch gekennzeichnet, dass** sowohl die erste als auch die zweite ringförmige Struktur einen elektrisch leitenden Halbring (128, 130) und einen elektrisch nicht leitenden Halbring (129, 131) enthält, wobei der erste leitende Halbring (128) zum Teil über dem vierten nicht leitenden Halbring (131) und der zweite nicht leitende Halbring (129) über dem dritten leitenden Halbring (130) angebracht ist.

8. Generatorstufe nach einem beliebigen der Ansprüche 1 bis 7, **dadurch gekennzeichnet, dass** die erste obere ringförmige Struktur (103) und die zweite untere ringförmige Struktur (104) durch mindestens zwei Abstandsstücke (132, 133) getrennt sind.

9. Generatorstufe nach einem beliebigen der Ansprüche 1 bis 8, **dadurch gekennzeichnet, dass** sie einen ersten und zweiten Kondensator (118, 119), eine erste und zweite Lastinduktivität (111, 112), ein erstes und zweites Abstandsstück (132, 133), eine erste, zweite, dritte und vierte Anschlussklemme (113, 114, 115, 116) sowie eine erste und zweite Funkenstrecke (120, 121) enthält.

10. Spannungsgenerator mit mindestens einer Stufe nach einem beliebigen der Ansprüche 1 bis 9.

11. Spannungsgenerator nach Anspruch 10 mit mindestens zwei übereinander angeordneten Stufen gemäß der Erfindung, **dadurch gekennzeichnet, dass** er ein diese Stufen umgebendes, röhrenförmiges Gehäuse (310) aufweist und ein erstes röhrenförmiges äußeres Gehäuse (311) aus elektrisch leitendem Material, wie z.B. Aluminium und darüber hinaus ein zweites röhrenförmiges inneres Gehäuse (312) aus elektrisch nicht leitendem Material, wie z. B. aus PVC, enthält, wobei das erste und zweite Gehäuse koaxial zueinander angebracht sind.

## Claims

1. Stage for a tension generator comprising at least a capacitor (118, 119) and two electrically connected load resistances or two load inductances (111, 112) comprising a rigid shell structure made of electrically insulating material (101) of cylindrical and flatted shape, comprising an axial channel (135) containing at least a capacitor (118, 119) and two load resistances or two load inductances (111, 112), coated with gel and electrically connected in a way that the at least a capacitor (118, 119) and two electrically connected load resistances or two load inductances (111, 112) which are electrically connected, are arranged between a first upper annular structure (103) and a second lower annular structure (104).

2. Stage defined according to claim 1 **characterised in that** the electrical connexions are composed of connecting clamps (113, 114, 115, 116) or of wired connexions.

3. Stage defined according to claim 1 and to claim 2, **characterised in that** the shell structure includes a first hollow part (107) with a first external tubular segment (141) and a second internal tubular segment (142), whereas these tubular segments are coaxial and attached together using an annular plate (143) at their bottom and a second part (108) in the shape of an annular plate.

4. Stage defined according to claim 1, **characterised in that** it comprises two half-spark gaps which are at least partly disposed in the axial channel and are connected to the capacitors, and **characterised in that** the second tubular segment (142) comprises two holes (144), one in the upper part, one in the lower part, these holes linking the interior of the first part of the shell with the channel (135), each of these holes allowing the passage of a half-spark gap.

5. Stage defined according to claim 1, or claim 2, or claim 3, or claim 4, **characterised in that** the shell structured mentioned above (101) is made of PVC.

6. Stage defined according to claim 1, or claim 2, or claim 3, or claim 4, or claim 5, **characterised in that** at least a capacitor (118, 119) and two load resistances or two load inductances (111, 112) which are electrically connected are coated with a silicon gel material (117).

7. Stage defined according to claim 1, or claim 2, or claim 3, or claim 4, or claim 5, or claim 6, **characterised in that** each of the first and the second annular structures comprises an electrically conductive half-ring (128, 130) and a non-electrically conductive half-ring (129, 131), the first electrically conductive half-ring (128) is partly placed above the fourth non-electrically conductive half-ring (131) and the second non-electrically conductive half-ring (129) is placed above the third electrically-conductive half-ring (130).

8. Stage defined according to claim 1, or claim 2, or claim 3, or claim 4, or claim 5, or claim 6, or claim 7, **characterised in that** the first upper annular structure (103) and the second lower annular structure (104) are separated by at least two distance pieces (132, 133).

9. Stage defined according to claim 1, or claim 2, or claim 3, or claim 4, or claim 5, or claim 6, or claim 7, or claim 8, **characterised in that** it comprises a first and a second capacitor (118, 119), a first and a second load inductance (111, 112), a first and a second distance piece (132, 133), a first, second, third and fourth connecting clamps (113, 114, 115, 116), a first and a second spark gap (120, 121).

10. Tension generator comprising at least one stage defined according to claim 1, or claim 2, or claim 3, or claim 4, or claim 5, or claim 6, or claim 7, or claim 8, or claim 9.

11. Tension generator according to claim 10, comprising a piling of at least two stages according to the invention and **characterised in that** it comprises a tubular envelope (310) around the stages mentioned above and comprising a first external envelope (311) of tubular form and made of electrically conductive material, for example aluminium and, on the other hand, a second internal envelope (312) of tubular form, made of non-electrically conductive material, for example PVC, whereas both first and second envelopes are disposed coaxially.

**Fig. 1**

Fig.6

Fig. 2

**Fig. 3**

Fig.4

Fig. 5

Fig. 7

**EP 2 660 977 B1**

**RÉFÉRENCES CITÉES DANS LA DESCRIPTION**

**Documents brevets cités dans la description**

- GB 401737 A

- FR 2823033